# FASCICULE DE BREVET EUROPEEN

(11) **EP 3 539 145 B1**
(45) Date de publication et mention de la délivrance du brevet: **28.04.2021**
(21) Numéro de dépôt: 17808786.2
(22) Date de dépôt: 08.11.2017
(51) Int. Cl.: H01J 37/32, H03H 7/38

(54) **CIRCUIT D'ADAPTATION D'IMPEDANCE ENTRE UN GÉNÉRATEUR ET UNE CHARGE À DES FRÉQUENCES MULTIPLES, ENSEMBLE COMPORTANT UN TEL CIRCUIT ET UTLISATION LIÉE**
SCHALTUNG ZUR IMPEDANZANPASSUNG ZWISCHEN EINEM GENERATOR UND EINER LAST BEI MEHREREN FREQUENZEN, ANORDNUNG MIT SOLCH EINER SCHALTUNG UND ZUGEHÖRIGE VERWENDUNG
CIRCUIT FOR IMPEDANCE MATCHING BETWEEN A GENERATOR AND A LOAD AT MULTIPLE FREQUENCIES, ASSEMBLY COMPRISING SUCH A CIRCUIT AND RELATED USE

(30) Priorité: 08.11.2016 FR 1660791
(43) Date de publication de la demande: 18.09.2019
(73) Titulaire: Centre National de la Recherche Scientifique, 75016 Paris (FR); Ecole Polytechnique, 91120 Palaiseau (FR)
(72) Inventeur: JOHNSON, Erik, 92130 Sèvres (FR); BOOTH, Jean-Paul, 91470 Boullay les Trous (FR)
(74) Mandataire: Gevers & Orès
(86) Numéro de dépôt international: PCT/EP2017/078673
(87) Numéro de publication internationale: WO 2018/087189

(56) Documents cités:
- WO-A2-2013/067031
- JP-A- 2002 118 428
- US-A- 3 461 372
- US-A- 4 679 007
- US-A1- 2007 021 088
- US-A1- 2008 079 513
- US-A1- 2012 075 033
- US-A1- 2012 105 147
- US-A1- 2012 306 367

## Description

L'invention concerne un circuit d'adaptation d'impédance entre une générateur et une charge à des fréquences multiples.

L'invention concerne également un ensemble comportant un générateur, une charge et un circuit d'adaptation d'impédance monté entre le générateur et la charge.

Il concerne encore une utilisation d'un tel ensemble.

L'invention peut trouver application dans différents domaines, et plus particulièrement pour une charge formée par un réacteur plasma couplé capacitivement.

Dans ce cas, on utilise de longue date un générateur alimentant le réacteur plasma couplé capacitivement avec un signal sinusoïdal (en tension), typiquement dans le domaine radiofréquence (RF), à savoir dans la gamme comprise entre 1MHz et 900 MHz. Dans la mesure où les caractéristiques d'impédance d'un réacteur plasma couplé capacitivement sont variables et généralement différentes de celles du générateur, on utilise un étage de charge et d'accord entre le générateur et le réacteur plasma pour réaliser une adaptation d'impédance (électrique).

Cette adaptation d'impédance vise à maximiser la puissance transmise entre le générateur et le réacteur plasma couplé capacitivement.

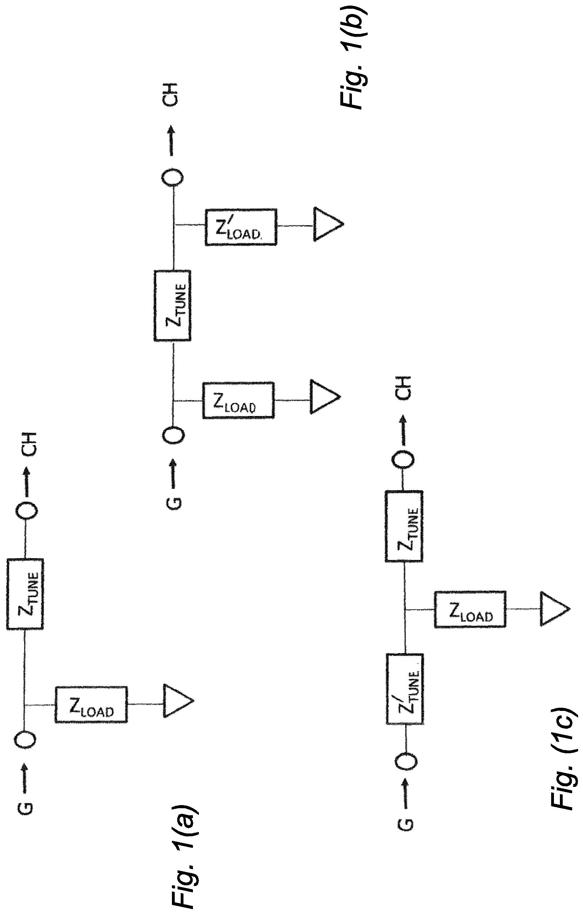

La figure 1, qui comprend les figures 1(a) à 1(c), représente trois configurations envisageables pour réaliser une telle adaptation d'impédance (une seule fréquence).

Sur la figure 1(a), l'étage d'adaptation d'impédance comporte un circuit, en forme de L, muni d'une impédance d'accord Z_{TUNE} monté en série entre le générateur G et le réacteur plasma CH et d'une impédance de charge Z_{LOAD} montée entre le générateur G et la masse (représentée par un triangle).

Sur la figure 1(b), le circuit est en forme de π et est obtenu en ajoutant, par rapport à la configuration en forme de L de la figure 1(a), une autre impédance de charge Z'_{LOAD} montée en parallèle entre la charge CH et la masse (représentée par un triangle), de sorte que l'impédance d'accord Z_{TUNE} est montée entre les deux impédances de charge Z_{LOAD}, Z'_{LOAD}.

Sur la figure 1(c), le circuit est en forme de T et est obtenu en ajoutant, par rapport à la configuration en forme de L de la figure 1(a), une autre impédance d'accord Z'_{TUNE} montée en série entre le générateur G et le circuit de la figure 1(a). En d'autre termes, le circuit comprend alors une autre impédance d'accord Z'_{TUNE} montée en série entre le générateur G et la charge CH de sorte que l'impédance de charge Z_{LOAD} est montée entre les deux impédances d'accord Z_{TUNE} et Z'_{TUNE}.

Les figures 1(a) à 1(c) sont illustratives et d'autres configurations sont donc envisageables.

Quelle que soit la configuration envisagée, le point commun entre les différentes configurations envisageables réside dans le fait que le circuit est muni, au minimum, d'une impédance d'accord Z_{TUNE} et d'une impédance de charge Z_{LOAD}. Ces impédances Z_{TUNE} ; Z_{LOAD} représentent des impédances de condensateurs (Z_{c} = 1/(jωC)) ou d'inductances (Z_{L}= jωL) employées à cet effet, à la fréquence f (f = (2π)/ω) de fonctionnement du générateur (signal sinusoïdal).

Grâce à cela, et dans la mesure où le signal d'alimentation du réacteur plasma présente une fréquence f donnée (celle du signal sinusoïdal), on peut réaliser une adaptation d'impédance sans difficultés particulières.

Beaucoup de réacteurs plasmas couplés fonctionnent encore avec cette solution pour réaliser une adaptation d'impédance entre le générateur et le réacteur.

On cherche cependant depuis quelques temps des solutions permettant de faire fonctionner un tel réacteur plasma avec un signal d'alimentation à fréquences multiples.

En effet, il a déjà été montré que l'utilisation d'un signal d'alimentation à fréquences multiples pour un tel réacteur plasma était bénéfique pour améliorer la performance et le contrôle du réacteur. Par exemple, dans le document WO2012/007483 A1, on propose d'alimenter un réacteur plasma couplé capacitivement avec un générateur fournissant un signal d'alimentation trapézoïdale périodique (lequel peut se décomposer avec une fréquence fondamentale et ses harmoniques). Le contrôle de la forme du signal d'alimentation (forme du trapèze et périodicité) permet alors de contrôler indépendamment le bombardement ionique et la puissance injectée.

Ceci est très intéressant.

Cependant, d'un point de vue pratique (industriel), il convient également que la puissance injectée par le générateur puisse être transmise efficacement au réacteur plasma.

Pour cela, une solution connue est de réaliser une adaptation d'impédance avec autant de générateurs et d'étages de charge et d'accord comportant un circuit tel que représenté sur la figure 1 que le nombre de fréquences (multiples) à gérer dans le signal. Dans ce cas, chaque générateur auquel est associé un circuit tel que représenté sur la figure 1 forme un ensemble fonctionnant pour une fréquence donnée, les différents ensembles ainsi formés étant agencés en parallèle et connectés au réacteur plasma. De ce fait, il est aussi nécessaire de prévoir des filtres pour chaque ensemble tel que défini précédemment pour éviter un retour d'un signal de fréquence donné, via le réacteur plasma, et provenant d'un autre ensemble. Ainsi, si l'on envisage de traiter N (N > 1) fréquences, il convient de prévoir N ensembles tels que définis précédemment et N-1 filtres par ensemble, soit N(N-1) filtres. En plus, cette solution nécessite un générateur/amplificateur indépendant pour chaque fréquence.

Cela peut fonctionner, mais on comprend que cette solution peut devenir lourde à implémenter et par ailleurs coûteuse.

On cherche donc actuellement d'autres solutions permettant non seulement de réaliser une adaptation d'impédance à des fréquences multiples mais également, et contrairement à la solution décrite précédemment, de ne mettre en œuvre qu'un générateur ainsi qu'un nombre réduit de composants pour assurer cette adaptation d'impédance entre le générateur et le réacteur plasma.

Un premier pas dans ce sens a été réalisé par l'invention proposée dans le document WO 2013/186381.

Dans ce document, la solution proposée consiste à prévoir un circuit d'adaptation d'impédance entre un seul générateur et le réacteur plasma, de conception particulière et dans lequel au moins un composant (un condensateur par exemple) présente une valeur réglable. Une difficulté rencontrée avec cette solution est que lorsque l'on effectue une adaptation d'impédance (en selon l'exemple, en réglant la valeur de la capacité du condensateur), pour une fréquence donnée (harmonique par exemple), cela implique une modification de l'impédance pour une autre fréquence (fréquence fondamentale par exemple).

Bien que cette solution permette d'obtenir une adaptation d'impédance avec une transmission de puissance acceptable entre le générateur et le réacteur plasma, son contrôle est délicat.

Cela vaut pour une application à un réacteur plasma couplé capacitivement et plus généralement pour toute charge. Les documents US2007021088 A1 et JP2002118428 A décrivent des exemples de circuits d'adaptation d'impédance entre une source et une charge.

Un objet de l'invention est donc de proposer un circuit d'adaptation d'impédance entre un générateur et une charge à fréquences multiples présentant des performances améliorées.

A cet effet, l'invention propose un circuit d'adaptation d'impédance selon la revendication indépendante. Ledit circuit étant apte à réaliser une adaptation d'impédance simultanée entre un générateur et une charge pour un signal d'alimentation comportant au moins une première fréquence et une deuxième fréquence distinctes l'une de l'autre, ledit circuit comprenant un étage d'adaptation d'impédance apte à réaliser l'adaptation d'impédance entre le générateur et la charge pour la première fréquence, cet étage comportant un circuit comprenant au moins une impédance d'accord destinée à être montée en série entre le générateur et la charge et une impédance de charge destinée à être montée entre le générateur et une masse, caractérisé en ce que ledit circuit d'adaptation d'impédance comporte, en outre, au moins une paire d'étages additionnels apte à réaliser l'adaptation d'impédance, simultanée, entre le générateur et la charge pour la deuxième fréquence, ladite paire d'étages additionnels comprenant :
- un premier étage additionnel comportant un circuit de charge monté en parallèle par rapport à l'impédance de charge de l'étage d'adaptation d'impédance, ledit circuit de charge comprenant au moins une inductance et un condensateur montés en série, et
- un deuxième étage additionnel comportant un circuit d'accord monté en série par rapport à l'impédance d'accord de l'étage d'adaptation d'impédance, ledit circuit d'accord comprenant au moins une inductance et un condensateur montés en parallèle,
l'étage d'adaptation d'impédance étant par ailleurs monté entre le premier étage additionnel et le deuxième étage additionnel.

Ce circuit comprend
- au moins une paire supplémentaire d'étages additionnels apte à réaliser l'adaptation d'impédance, simultanée, entre le générateur et la charge pour une troisième fréquence distincte desdites première et deuxième fréquences, ladite au moins une paire supplémentaire d'étages additionnels comportant :
   - un premier étage additionnel supplémentaire comportant un circuit de charge monté en parallèle par rapport à l'impédance de charge de l'étage d'adaptation d'impédance, ledit circuit de charge comprenant au moins une inductance et une condensateur montés en série,
   - un deuxième étage additionnel supplémentaire comportant un circuit d'accord monté en série par rapport à l'impédance d'accord de l'étage d'adaptation d'impédance, ledit circuit d'accord comprenant au moins un inductance et une condensateur montés en parallèle,
   l'ensemble formé par l'étage d'adaptation d'impédance ainsi que par la paire d'étages additionnels étant par ailleurs monté entre le premier étage additionnel supplémentaire et le deuxième étage additionnel supplémentaire ;
- la valeur d'au moins l'un de l'inductance ou du condensateur de l'un au moins des étages additionnels est réglable ;
- le circuit de l'étage d'adaptation d'impédance est constitué d'une impédance d'accord destinée à être montée en série entre le générateur et la charge et d'une impédance de charge destinée à être montée entre le générateur et ladite masse ;
- l'impédance d'accord comprend une inductance montée en série avec un condensateur et l'impédance de charge comprend un condensateur ;
- l'impédance d'accord est constitué d'une inductance montée en série avec un condensateur et l'impédance de charge est constitué d'un condensateur ;
- le circuit comprend en outre une autre impédance de charge destinée à être montée entre la charge et ladite masse de sorte que l'impédance d'accord est montée entre les deux impédances de charge ;
- le circuit comprend en outre une autre impédance d'accord destinée à être montée en série entre le générateur et la charge de sorte que l'impédance de charge est montée entre les deux impédances d'accord.

L'invention propose également un ensemble comprenant :
- une charge, et
- un générateur apte à transmettre à la charge un signal d'alimentation comportant au moins une première fréquence et une deuxième fréquence distinctes l'une de l'autre,
caractérisé en ce que ledit ensemble comprend en outre un circuit d'adaptation d'impédance selon l'invention monté entre le générateur et la charge de sorte que d'une part, le premier étage additionnel qui comporte le circuit de charge le plus externe dudit circuit d'adaptation d'impédance soit connecté au générateur et de sorte que d'autre part, le deuxième étage additionnel qui comporte le circuit d'accord le plus externe dudit circuit d'adaptation d'impédance soit connecté à la charge.

Cet ensemble pourra comprend l'une au moins des caractéristiques suivantes, prises seules ou en combinaison :
- la première fréquence est une fréquence fondamentale dudit signal d'alimentation et la deuxième fréquence, et le cas échéant toute fréquence supplémentaire, est l'une de ses harmoniques ;
- un capteur de fréquence situé entre le générateur et ledit circuit d'adaptation d'impédance ;
- la charge est un réacteur plasma couplé capacitivement.

Enfin, l'invention propose une utilisation d'un ensemble selon l'invention muni dudit capteur de fréquence et dans lequel la charge est un réacteur plasma couplé capacitivement, utilisation dans laquelle le générateur transmet un signal d'alimentation ne comportant qu'une seule fréquence en direction du réacteur plasma couplé capacitivement, et dans laquelle on analyse les données fréquentielles issues du capteur de fréquences, en retour du réacteur plasma couplé capacitivement, pour déterminer si un procédé de gravure en cours dans le réacteur plasma est terminé ou non.

D'autres caractéristiques, buts et avantages de l'invention ressortiront à la lecture de la description faite en référence aux dessins annexés donnés à titre d'exemple, pour lesquels :
- la figure 2 représente un schéma général d'un ensemble conforme à un exemple et comprenant un générateur, une charge et; disposé entre le générateur et la charge un circuit d'adaptation d'impédance ;
- la figure 3 représente un schéma plus précis du mode de réalisation selon un exemple représenté sur la figure 2 dans lequel les composants du circuit d'adaptation d'impédance sont précisés ;
- la figure 4, qui comporte les figures 4(a) et 4(b), représente sur la figure 4(a) le fonctionnement de principe d'une réalisation sans mettre en œuvre l'invention dans une représentation de Smith et sur la figure 4(b) le fonctionnement de principe du mode de réalisation de la figure 3, dans une représentation de Smith ;
- la figure 5 représente un mode de réalisation conforme à l'invention ;
- la figure 6, qui comprend les figures 6(a), 6(b) et 6(c), représente des résultats issus d'une simulation numérique du comportement du mode de réalisation de la figure 5 ;
- la figure 7 représente des résultats d'un test expérimental réalisé avec le mode de réalisation de la figure 5 ;
- la figure 8 représente les résultats d'un autre test expérimental réalisé avec le mode de réalisation de la figure 5 ;
- la figure 9 reprend la figure 2 dans le cas où un capteur de fréquences est prévu en sortie du générateur.

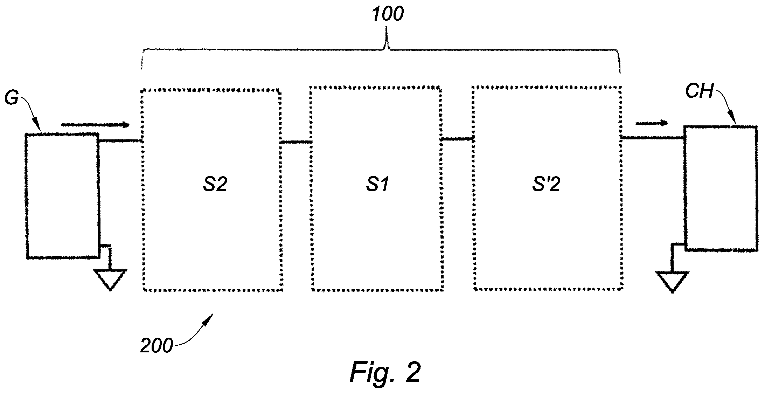

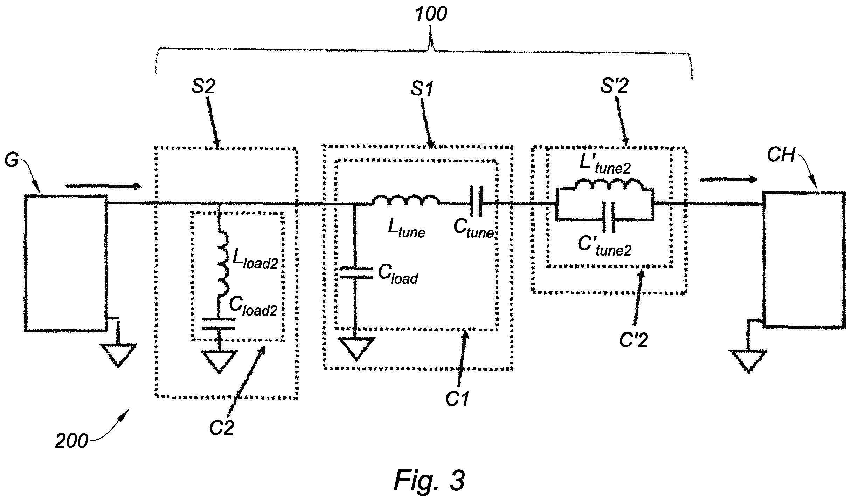

Un mode de réalisation selon un exemple est représenté sur les figures 2 et 3.

Sur ces figures, on a représenté un ensemble 200 comportant une générateur G, une charge CH et un circuit d'adaptation d'impédance 100 situé entre le générateur G et la charge CH.

Le circuit d'adaptation d'impédance 100 est apte à réaliser une adaptation d'impédance simultanée entre le générateur G et la charge CH pour un signal d'alimentation comportant au moins une première fréquence et une deuxième fréquence distinctes l'une de l'autre.

Ce circuit d'adaptation d'impédance 100 comprend un étage S1 d'adaptation d'impédance apte à réaliser l'adaptation d'impédance entre le générateur et la charge pour la première fréquence.

Cet étage S1 comporte un circuit C1 conforme à celui de la figure 1(a). Ici et à titre d'exemple, l'impédance d'accord Z_{TUNE} correspond à une association en série d'une inductance Lₜᵤₙₑ et d'un condensateur Cₜᵤₙₑ et par ailleurs, l'impédance de charge Z_{LOAD} correspond à un condensateur de charge C_{load}.

Le circuit 100 d'adaptation d'impédance comporte, en outre, au moins une paire d'étages additionnels S2, S'2 apte à réaliser l'adaptation d'impédance, simultanée, entre le générateur et la charge pour la deuxième fréquence.

Plus précisément, la paire d'étages additionnels S2, S'2 comprend :
- un premier étage additionnel S2 comportant un circuit de charge C2 monté en parallèle par rapport à l'impédance de charge Z_{LOAD} (par exemple un condensateur C_{load}) de l'étage S1 d'adaptation d'impédance, ledit circuit de charge C2 comprenant au moins une inductance L_{load2} et un condensateur C_{load2} montés en série, et
- un deuxième étage additionnel S'2 comportant un circuit d'accord C'2 monté en série par rapport à l'impédance d'accord Z_{TUNE} (par exemple une inductance Lₜᵤₙₑ en série avec un condensateur Cₜᵤₙₑ) de l'étage S1 d'adaptation d'impédance, ledit circuit d'accord C'2 comprenant au moins un inductance L'ₜᵤₙₑ₂ et un condensateur C'ₜᵤₙₑ₂ montés en parallèle,
l'étage de charge et d'accord S1 étant par ailleurs monté entre le premier étage additionnel S2 et le deuxième étage additionnel S'2.

En pratique, il convient alors de choisir les valeurs des condensateurs et impédances à utiliser dans chacun des circuits C1, C2 et C'2. Cela dépend notamment de la nature et des caractéristiques de la charge CH.

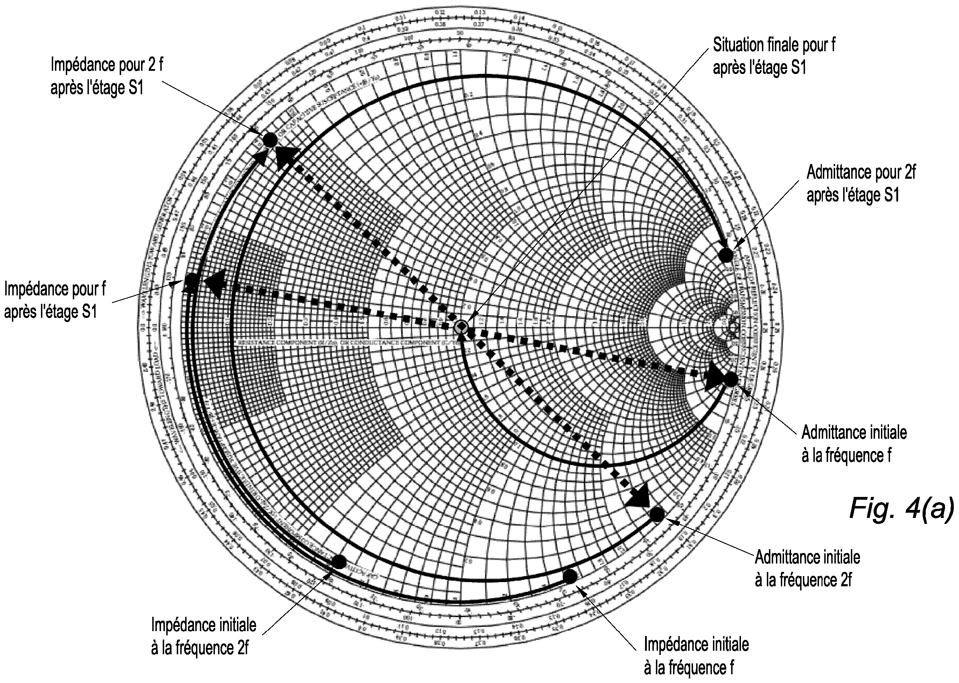

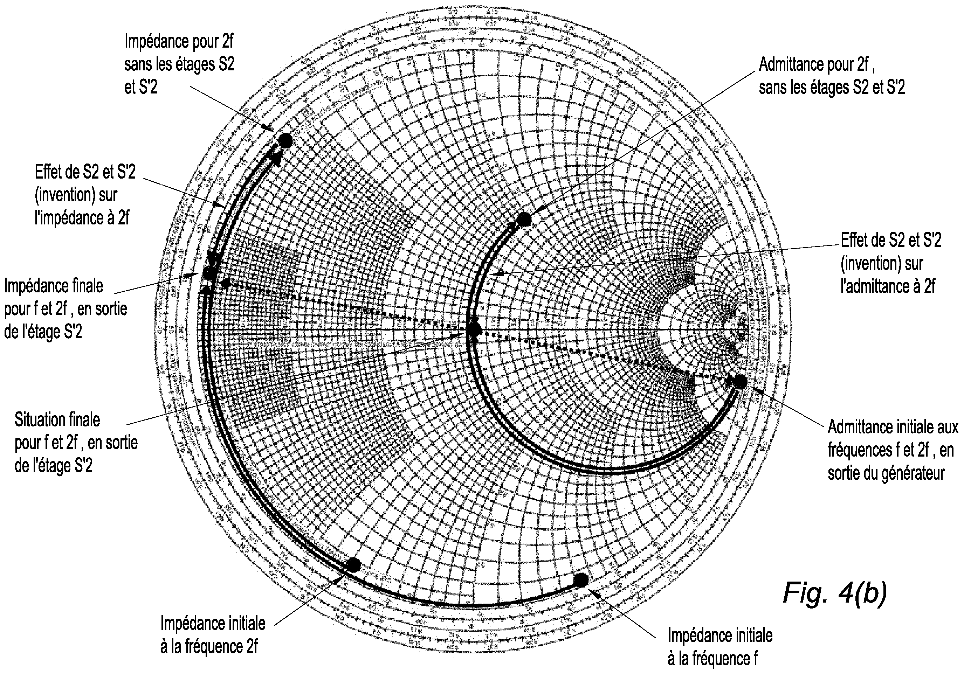

La figure 4, qui comprend les figures 4(a) et 4(b), est une représentation de Smith permettant d'expliquer le fonctionnement de l'adaptation d'impédance.

Plus précisément, la figure 4(a) est une représentation de Smith sans mettre en œuvre l'invention. Pour cela, l'adaptation ne s'effectue qu'avec un étage du type de celui de S1 de la figure 3, entrant donc dans le cadre défini par la figure 1(a), directement connecté au générateur G et à la charge CH.

Et la figure 4(b) est une représentation de Smith en mettant en œuvre un exemple conformément à la figure 3.

Une représentation de Smith (abaque) permet de montrer la valeur de la partie réelle et de la partie imaginaire d'une impédance (Z) ou admittance (Y= 1/Z). Cette représentation est largement utilisée dans les problèmes liés à l'adaptation d'impédance. En effet, cette représentation est réalisée dans le champ complexe et plus précisément dans un plan (2D) d'un coefficient de réflexion complexe et est normalisé, le plus souvent avec une impédance, une admittance ou les deux avec différents domaines pour pouvoir faire la distinction.

Pour l'application considérée ici, on peut prendre en compte une impédance normalisée, d'une valeur de 50 Ohms (le plus communément utilisé). Cela correspond, sur les figures 4(a) et 4(b), au petit cercle au centre de la figure concernée.

Sur la figure 4(a), on note tout d'abord, pour la première fréquence (fondamentale), l'effet de l'étage S1. Par exemple, pour l'impédance, on part du point de départ « impédance initiale à la fréquence f » (avant l'étage S1 et donc en sortie du générateur) et on suit la flèche. Ceci est tout à fait classique. Sur cette même figure 4(b), on note ensuite ce qui se passe sur la fréquence 2f (première harmonique), en partant du point « impédance initiale à la fréquence 2f » (avant l'étage S1 et donc en sortie du générateur) et en suivant la flèche.

L'adaptation d'impédance est de mauvaise qualité pour la fréquence 2f.

Sur la figure 4(b), on note tout d'abord, pour la première fréquence (fondamentale) l'effet du seul étage S1 (impédance ou admittance), à savoir sans les étages S2 et S'2. Par exemple pour l'impédance, on part du point « impédance initiale à la fréquence f » et on suit la flèche. Ceci est identique à ce qui se passe dans ces conditions sur la figure 4(a). Sur cette même figure 4(b), on note ensuite ce qui se passe sur la fréquence 2f (première harmonique), avec seulement un étage S1 classique, à savoir sans les étages S2 et S'2 (figures 2 et 3). Par exemple pour l'impédance, on part du point « impédance initiale à la fréquence 2f » et on suit la flèche. Il s'agit du même comportement qui a été décrit précédemment sur la figure 4(a).

L'adaptation d'impédance est donc de mauvaise qualité pour la fréquence 2f (petits cercles les plus hauts sur la figure 4(b)).

C'est à partir de ce moment que la figure 4(b) diffère notablement de la figure 4(a).

En effet, ensuite, sur cette même figure 4(b), on note l'effet technique lié à la mise en œuvre des étages S2 et S'2 tels que proposés dans le cadre de l'invention sur la fréquence 2f.

Le point de fonctionnement (admittance, impédance) est, pour cette fréquence 2f, ramené à celui de la fréquence f qui est géré par l'étage S1. L'adaptation d'impédance à la fréquence 2f est donc de très bonne qualité et même d'une qualité similaire à celle obtenue dans le cas d'une fréquence unique (cas classique).

Enfin, on note sur cette figure 4(b), que l'adaptation d'impédance réalisée pour la fréquence 2f n'a pas d'impact sur l'adaptation d'impédance à la fréquence f. Il y a une indépendance entre la gestion de l'adaptation d'impédance entre les deux fréquences. Cette indépendance n'est en fait pas nécessairement absolue, mais déterminable par la finesse de la réponse en fréquence des circuits (le facteur de qualité, "Q") dans les étages S2 et S'2.

La conception proposée sur les figures 2 et 3, adaptée pour gérer deux fréquences distinctes est généralisable à N (N > 2) fréquences distinctes.

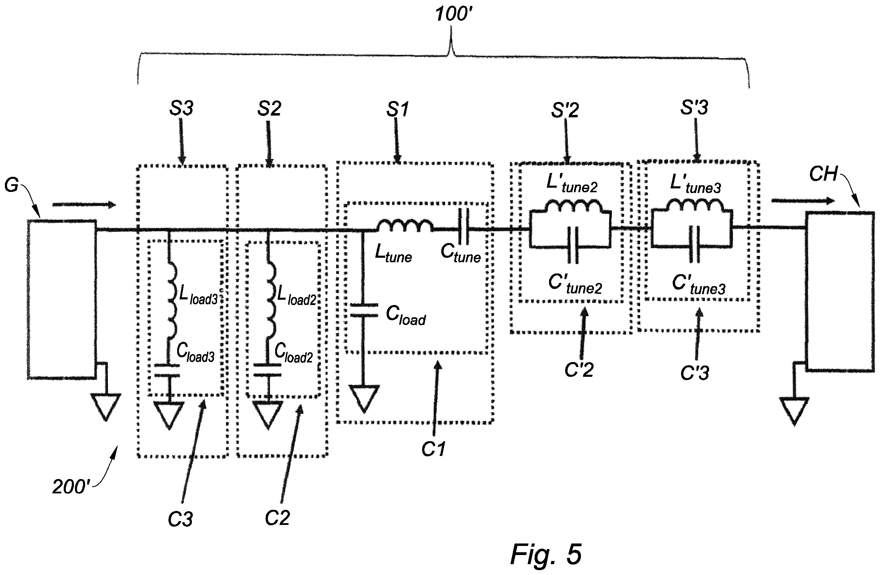

La figure 5 représente un mode de réalisation selon l'invention qui montre en pratique comment gérer une troisième fréquence (cas N = 3), distincte des deux premières fréquences.

Ce mode de réalisation s'appuie sur l'exemple de la figure 3 et montre où et comment ajouter des composants pour pouvoir traiter une troisième fréquence, distincte des deux premières fréquences.

Ainsi, en plus des composants du circuit 100 d'adaptation d'impédance décrit précédemment, le circuit 100' d'adaptation d'impédance prévu dans ce cas comprend au moins une paire supplémentaire d'étages additionnels S3, S'3 apte à réaliser l'adaptation d'impédance, simultanée, entre le générateur G et la charge CH pour une troisième fréquence distincte desdites première et deuxième fréquences.

Plus précisément, ladite au moins une paire supplémentaire d'étages additionnels S3, S'3 comporte :
- un premier étage additionnel S3 supplémentaire comportant un circuit de charge C3 monté en parallèle par rapport à l'impédance de charge Z_{LOAD} (par exemple un condensateur C_{load}) de l'étage S1 d'adaptation d'impédance, ledit circuit de charge C3 comprenant au moins une inductance L_{load3} et une condensateur C_{load3} montés en série, et
- un deuxième étage additionnel S'3 supplémentaire comportant un circuit d'accord C'3 monté en série par rapport à l'impédance d'accord Z_{TUNE} (par exemple une inductance Lₜᵤₙₑ en série avec un condensateur Cₜᵤₙₑ) de l'étage S1 d'adaptation d'impédance, ledit circuit d'accord C'3 comprenant au moins une inductance L'ₜᵤₙₑ₃ et un condensateur C'ₜᵤₙₑ₃ montés en parallèle, l'ensemble formé par l'étage S1 d'adaptation d'impédance ainsi que par la paire supplémentaire d'étages additionnels S2, S'2 étant par ailleurs monté entre le premier étage additionnel S3 supplémentaire et le deuxième étage additionnel S'3 supplémentaire.

En pratique, on choisira les valeurs des inductances et condensateurs des circuits C3 et C'3 pour assurer une adaptation d'impédance de bonne qualité pour la troisième fréquence (3f, par exemple).

Comme indiqué précédemment, ceci est généralisable à d'autres fréquences (N > 3).

A chaque fois, il suffit alors d'ajouter un étage conforme, dans sa conception, à l'étage S2 en sortie du générateur G et un étage conforme, dans sa conception, à l'étage S'2 avant l'entrée de la charge CH.

Avec les circuits 100, 100' d'adaptation d'impédance décrits précédemment, on peut alors construire un ensemble 200, 200' comprenant :
- une charge CH, et
- un générateur G apte à transmettre à la charge un signal d'alimentation comportant au moins une première fréquence et une deuxième fréquence distinctes l'une de l'autre,
dans lequel ledit ensemble 200, 200' comprend en outre un circuit 100, 100' d'adaptation d'impédance selon l'une des revendications précédentes monté entre le générateur G et la charge CH de sorte que d'une part, le premier étage additionnel S2, S3 qui comporte le circuit de charge C2, C3 le plus externe dudit circuit 100, 100' d'adaptation d'impédance soit connecté au générateur G et de sorte que d'autre part, le deuxième étage additionnel S'2, S'3 qui comporte le circuit d'accord C'2, C'3 le plus externe dudit circuit 100, 100' d'adaptation d'impédance soit connecté à la charge CH.

Dans cet ensemble 200, 200', la première fréquence pourra être une fréquence fondamentale dudit signal d'alimentation et la deuxième fréquence, et/ou le cas échéant toute fréquence supplémentaire, l'une de ses harmoniques.

La charge CH pourra être un réacteur plasma couplé capacitivement. En variante, il pourra aussi s'agir d'une autre charge électrique avec une impédance caractéristique différente de celle du générateur G, par exemple une antenne, un câble, un amplificateur ou circuit d'isolation, un transducteur, une bobine, ou encore un réacteur plasma à couplage inductif.

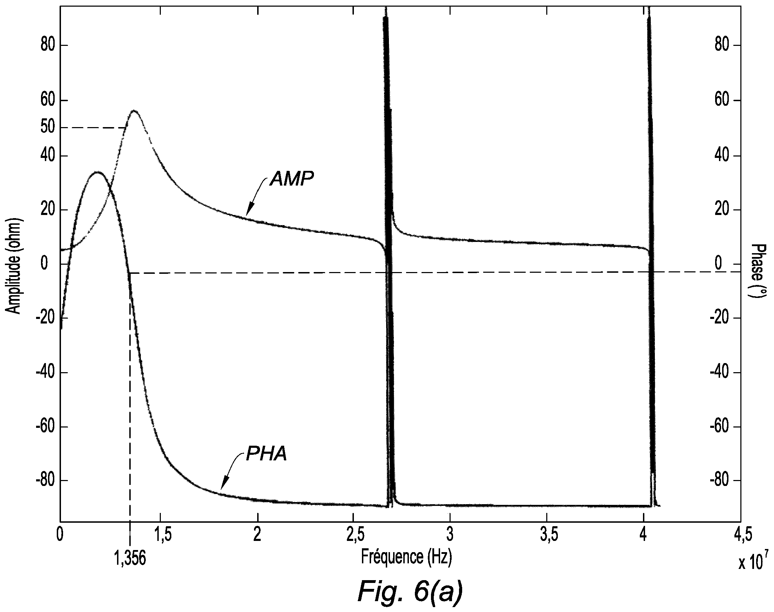

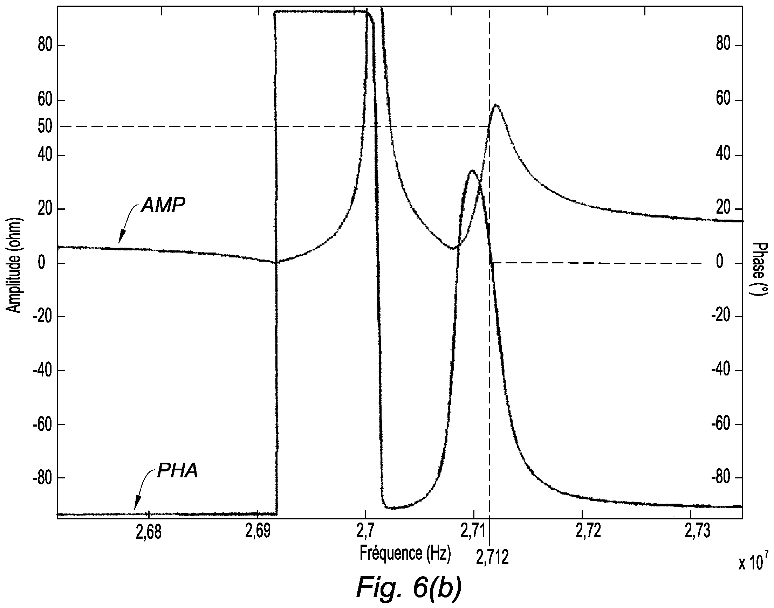

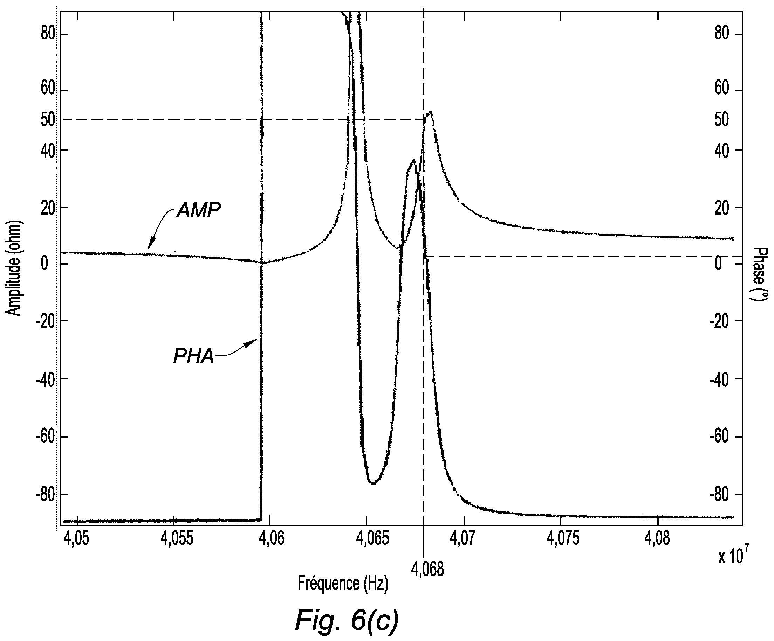

La figure 6 montre les résultats d'une simulation numérique réalisée avec le circuit 100' d'adaptation d'impédance représenté sur la figure 5. La figure 6 comprend les figures 6(a), 6(b) et 6(c), les figures 6(b) et 6(c) étant des vues qui se focalisent sur les fréquences 2f et 3f respectivement.

Pour cette simulation, les conditions suivantes ont été prises en compte.

On se base sur la réalisation de la figure 5.

Le générateur G est modélisé comme ayant une impédance caractéristique de 50 Ohms.

En ce qui concerne la charge CH, elle peut être assimilée à un réacteur plasma couplé capacitivement. Ainsi, elle est considérée comme présentant une impédance variable avec la fréquence. Elle est modélisée par les valeurs suivantes :
- capacité de la charge C_{CH} = 700.10⁻¹² (Farad);
- résistance de la charge R_{CH} = 5 (Ohm) ; et
- inductance de la charge L_{CH} =14.10⁻⁹ (Henry).

On notera que pour permettre la transmission optimale de puissance, on prévoit une résistance de charge de 5 Ohms.

En ce qui concerne le circuit C1 ("matchbox"), il est modélisé par les valeurs suivantes :
- capacité C_{load} = 7.10⁻¹⁰ (Farad);
- capacité Cₜᵤₙₑ = 3,3.10⁻⁹ (Farad); et
- inductance Lₜᵤₙₑ = 4.10⁻⁷ (Henry).

En ce qui concerne le circuit C2, on a les valeurs suivantes :
- capacité C_{load2} = 5,3.10⁻¹² (Farad); et
- inductance L_{load2} = 6,7.10⁻⁶ (Henry).

En ce qui concerne le circuit C'2, on a les valeurs suivantes :
- capacité C'_{load2} = 1,3.10⁻⁸ (Farad);
- inductance L'_{load2} = 2,7.10⁻⁹ (Henry).

En ce qui concerne le circuit C3, on a les valeurs suivantes :
- capacité C_{load3} = 1,9.10⁻¹² (Farad);
- inductance L_{load3} = 7,9.10⁻⁶ (Henry).

En ce qui concerne le circuit C'3, on a les valeurs suivantes :
- capacité C'_{load3} = 10⁻⁸ (Farad);
- inductance L'_{load3} = 1,5.10⁻⁹ (Henry).

Pour établir ces valeurs, l'approche consiste dans un premier temps à assurer une adaptation d'impédance à la fréquence f (13,56 MHz). Pour cela, les valeurs de l'inductance Lₜᵤₙₑ et des condensateurs C_{load}, Cₜᵤₙₑ du circuit C1 (« matchbox ») de la figure 5 sont réglées en choisissant une valeur d'inductance facilement réalisable, puis en calculant les valeurs précises de la capacité de chaque condensateur.

Puis, dans un deuxième temps, les valeurs des condensateurs et inductances des circuits C2, C'2, C3 et C'3 du circuit 100' d'adaptation d'impédance de la figure 5 sont réglées pour que le générateur G voit une impédance de 50 Ohms aux fréquences 2f (27,12MHz) et 3f (40,68 MHz), en affectant pas ou peu la condition d'adaptation d'impédance à la fréquence f 13,56MHz). Aucun ajustement n'est réalisé pour le circuit C1 après l'ajout des circuits C2, C'2, C3 et C'3.

Sur la figure 6, on a représenté l'évolution de la phase (PHA, en degrés) et de l'amplitude (AMP, en Ohms) de l'impédance vue par le générateur G en fonction de la fréquence (Hz) du signal. On constate, qu'aux fréquences f (13,56MHz), 2f et 3f, l'amplitude AMP et la phase PHA présentent des valeurs proches, respectivement, de 50 Ohms et 0° (cf. traits en pointillés), ce qui donne une adaptation d'impédance parfaite ou quasi-parfaite. Cela signifie qu'une adaptation d'impédance similaire est obtenue pour ces trois fréquences f, 2f et 3f, et par ailleurs que cette adaptation d'impédance est de bonne qualité.

Une installation expérimentale, reprenant le mode de réalisation de la figure 5, a ensuite été mise en œuvre.

L'installation expérimentale prévoit un circuit 100' d'adaptation d'impédance conforme à celui de la figure 5 (réel) et la charge a été modélisée en définissant sa résistance, sa capacité et son inductance. On a alors mesuré la puissance réfléchie en entrée de l'installation expérimentale (entrée de l'ensemble 200' de la figure 5 où le générateur est branché), en supposant la présence d'un générateur d'impédance caractéristique de 50 Ohm.

A noter que les résultats de la simulation ont pu donner des valeurs utilisables pour les composants des différents circuits C1, C2, C'2, C3 et C'3 du circuit 100', réel, d'adaptation d'impédance.

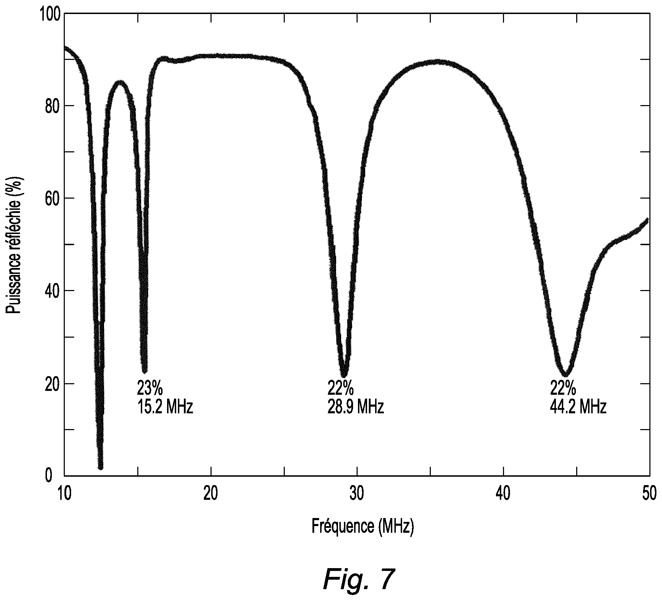

La figure 7 représente d'ailleurs cette mesure (en ordonnées, en % de la puissance injectée) en fonction de la fréquence (en abscisses).

On constate là également, comme dans le cas de la simulation numérique, la présence de trois creux aux fréquences de 15,2 MHz, 28,9 MHz et 44,2MHz, avec des valeurs de taux de réflexion similaires et faibles pour les trois fréquences (taux de réflexion de l'ordre de 22%). Cela confirme, sur le plan expérimental, les possibilités offertes par l'invention pour l'adaptation d'impédance à des fréquences multiples.

On note que, sur ces résultats expérimentaux, les fréquences ne sont pas exactement de 13,56MHz, 27,12 MHz et 40,68MHz, mais qu'elles présentent toutes un léger décalage vers des fréquences plus élevées. Cela est dû à la présence d'inductances parasites au sein de l'installation expérimentale utilisée. Cela ne remet pas en cause pour autant le fait que les tests expérimentaux réalisés viennent confirmer les résultats issus de la simulation numérique.

Enfin, une autre installation expérimentale a été mise en œuvre.

Cette autre installation expérimentale reprend l'installation expérimentale décrite précédemment, mais en utilisant un véritable réacteur plasma comme charge. On comprend donc que le circuit 100' d'adaptation d'impédance est celui de la figure 5.

Les caractéristiques du réacteur plasma sont les suivantes. Il s'agit d'un réacteur à couplage capacitif (CCP) muni de deux électrodes. Chaque électrode se présente sous la forme d'un cylindre de 10cm de diamètre. L'une des électrodes est à la masse et entourée par un cylindre de blindage à la masse. La distance entre les deux électrodes est de 3cm. Le milieu considéré est de l'Argon, à une pression de 200 mTorr.

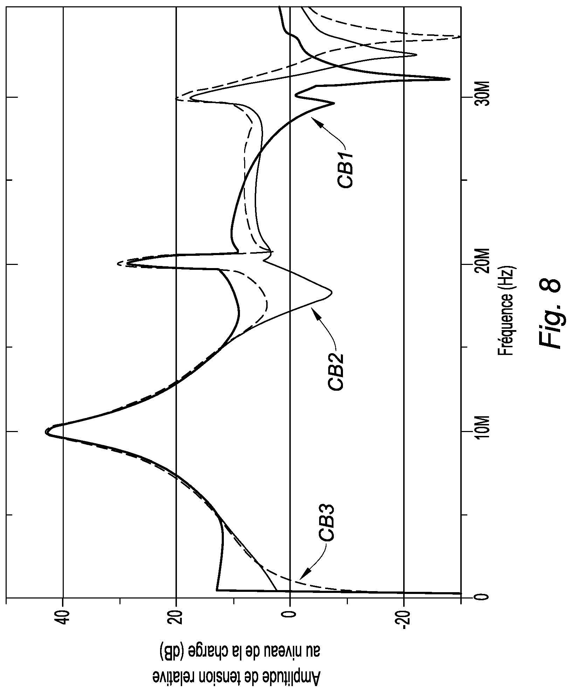

Sur la figure 8, on a représenté la transformée de Fourier de la forme d'onde en tension en entrée du réacteur plasma (amplitude relative en dB, en ordonnées) en fonction de la fréquence (abscisses). Pour des raisons de disponibilité d'un capteur adéquat aux conditions expérimentales, la puissance réfléchie n'a pas pu être mesurée.

Ainsi, sur la figure 8, la courbe CB3 montre qu'une adaptation d'impédance de bonne qualité peut être effectuée pour les trois fréquences 1f, 2f et 3f. Cette figure 7 montre également qu'on peut faire l'adaptation d'impédance, seulement sur deux fréquences, 1f et 2f (c'est la courbe CB1) ou 1f et 3f (c'est la courbe CB2).

On note toutefois sur cette figure 8 que la fréquence f est de l'ordre de 10 MHz. Ceci est lié, comme expliqué précédemment à l'existence d'inductances parasites et par ailleurs aux problèmes pratiques de câblage mal adaptés disponibles pour la mise en œuvre de cette installation expérimentale comportant un véritable réacteur plasma comme charge.

Ces résultats expérimentaux additionnels viennent quoiqu'il en soit corroborer ceux obtenus par simulation numérique et sur une installation expérimentale auquel est associé une modélisation pour la charge.

Il convient de noter que, dans le cadre de l'invention, on peut prévoir, toujours dans le cadre de la figure 1(a), une impédance de charge Z_{LOAD} et une impédance d'accord Z_{TUNE} pour l'étage S1 d'adaptation d'impédance, qui est différente de ce qui est plus précisément proposé sur les figures 3 et 5. Par exemple, on peut prévoir une inductance supplémentaire, après Cₜᵤₙₑ, en série avec Lₜᵤₙₑ et Cₜᵤₙₑ (figures 3, 5 ou 9). Selon un autre exemple, on peut prévoir de supprimer Lₜᵤₙₑ et de ne conserver que Cₜᵤₙₑ. Dans ce cas, une adaptation d'impédance parfaite à plusieurs fréquences n'est pas garantie, mais une amélioration, par rapport à l'art antérieur, de l'accord à plusieurs fréquences est possible.

Il convient également de noter que, dans le cadre de l'invention, on peut prévoir, pour l'étage S1 d'adaptation d'impédance, une configuration conforme à celle de la figure 1(b) ou à celle de la figure 1(c). Dans ces cas, une adaptation d'impédance parfaite à plusieurs fréquences n'est pas garantie, mais une amélioration, par rapport à l'art antérieur, de l'accord à plusieurs fréquences est également possible.

Dans la description qui précède, on a présenté des circuits dans lesquels les valeurs d'inductance ou des condensateurs mises en œuvre dans les circuits, permettant de traiter les fréquences 2f, 3f et ainsi de suite, sont constantes.

Il peut cependant être particulièrement intéressant de prévoir que, pour l'un au moins des circuits C2, C'2, C3 et C'3, la valeur d'au moins l'un de l'inductance ou du condensateur de l'un au moins de ces circuits ou des étages additionnels S2, S'2 ; S3, S'3 (cela revient au même) soit réglable. Cela permet de rendre le circuit 100, 100' plus versatile pour différents types de charges CH (en particulier différents types de réacteurs plasmas) dont l'impédance caractéristique est connue (cas le plus général) ou non.

En pratique, et généralement, l'impédance caractéristique du générateur G est fixée (connue par conception). L'invention consiste alors, pour une charge CH donnée qui présente donc une impédance caractéristique associée, de réaliser une adaptation d'impédance de la charge CH compte tenu de celle du générateur G. Ainsi, sur l'exemple présenté précédemment, le générateur G présente une impédance de 50 Ohm (cas classique) et la charge peut être quelconque, mais en l'occurrence dans l'exemple considérée tel que son impédance caractéristique puisse être modélisée par une capacité C_{CH} = 700.10⁻¹² Farad et une résistance de R_{CH} = 5 Ohm.

Mais, l'invention trouve également une application dans le cas où l'impédance de la charge CH est fixée (connue par conception) et on cherche à réaliser une adaptation d'impédance du générateur G compte tenu de celle de la charge CH. Ainsi, si l'on reprend l'exemple présenté précédemment, la charge est définie par une impédance caractéristique correspondant à une capacité C_{CH} = 700.10⁻¹² Farad et une résistance de R_{CH} = 5 Ohm et le générateur G serait modélisé par une résistance de 50 Ohm. Cela vaut pour l'ensemble des schémas des figures 1(a), 1(b) et 1(c). Dans ce cas également, on voit bien l'intérêt d'avoir des valeurs réglables des différentes capacités et inductances pour pouvoir, avec une charge CH d'impédance caractéristique connue, s'adapter à un générateur G dont l'impédance est connue (cas le plus général), mais en tout cas non classique (cas classique ; 50 Ohm) ou non.

Finalement, la présente invention présente plusieurs avantages.

Ainsi, la solution proposée dans la présente invention ne met en œuvre qu'un seul générateur et ne nécessite qu'un nombre réduit de composants pour fonctionner efficacement. En d'autres termes, par rapport à une solution consistant, pour N (N > 1) multiples fréquences, à prévoir N générateurs et autant de circuits d'adaptation d'impédance ainsi que N(N-1) filtres, le nombre de composants est notablement réduit et par suite, le coût.

De plus, il convient de noter que la solution proposée dans la présente invention peut être mise en œuvre sur des circuits d'adaptation d'impédance existants. En effet, si l'on reprend par exemple la conception de base illustrée sur la figure 3, il suffit, par rapport à un circuit d'adaptation d'impédance classique (étage S1 seulement), d'ajouter de part et d'autre de celui-ci, l'étage S2 et l'étage S'2 ou d'autres. Ceci n'était pas envisageable avec la conception proposée dans le document WO 2013/186381.

Enfin, la conception du circuit 100, 100' d'adaptation d'impédance entre le générateur et la charge implique que l'accord pour une fréquence donnée (par exemple une harmonique) est indépendant de l'accord pour une autre fréquence (par exemple la fréquence fondamentale). Par rapport à la solution proposée dans le document WO 2013/186381, les performances de l'adaptation d'impédance sont donc améliorées.

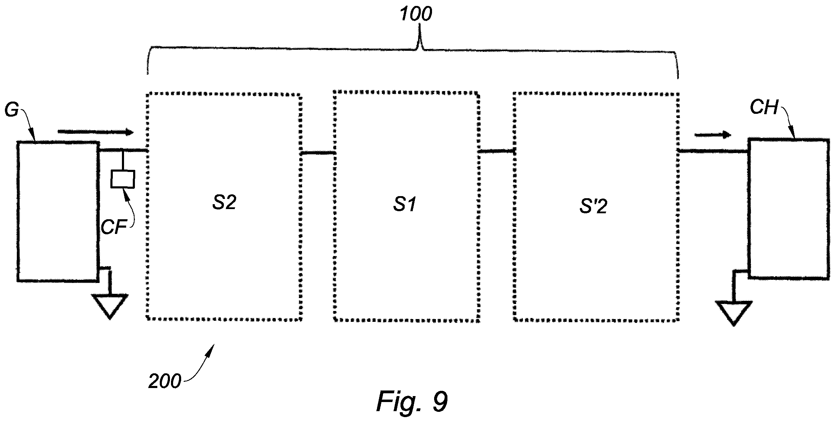

Il convient finalement d'ajouter que chaque ensemble 200, 200' peut être modifié pour lui adjoindre, entre le générateur G et le circuit d'adaptation d'impédance 100, 100', un capteur de fréquences CF. Une illustration a été faite sur la figure 9, dans le cas d'une application à l'ensemble 200.

En effet, avec ce capteur de fréquences et pour une application à un réacteur plasma couplé capacitivement, cela permet d'utiliser ledit ensemble 200, 200' d'une manière particulière. Dans cette utilisation, on transmet un signal d'alimentation ne comportant qu'une seule fréquence en direction du réacteur plasma couplé capacitivement, et on analyse les données fréquentielles issues du capteur CF de fréquences, en retour du réacteur plasma couplé capacitivement, pour déterminer si un procédé de gravure en cours dans le réacteur plasma est terminé ou non.

Il existe déjà différentes techniques pour déterminer si un procédé de gravure en cours dans le réacteur plasma est terminé ou non. L'une de ces techniques vise d'ailleurs à employer un capteur de fréquences pour détecter les harmoniques liées aux instabilités du plasma. Toutefois, du fait que les circuits d'adaptation d'impédance classiques ne laissent passer qu'une seule fréquence, le capteur est alors monté entre le circuit d'adaptation d'impédance et le réacteur plasma, ce qui complique grandement la mesure.

Ici, grâce à l'invention, on peut placer un capteur de fréquences en sortie du générateur. De plus, ce capteur peut être tout à fait basique.

## Revendications

1. Circuit d'adaptation d'impédance (100, 100') apte à réaliser une adaptation d'impédance simultanée entre le générateur (G) et la charge (CH) pour un signal d'alimentation comportant au moins une première fréquence, une deuxième fréquence et une troisième fréquence distinctes l'une de l'autre, ledit circuit (100) comprenant :
• un étage (S1) d'adaptation d'impédance apte à réaliser l'adaptation d'impédance entre le générateur et la charge pour la première fréquence, cet étage (S1) comportant un circuit (C1) comprenant au moins une impédance d'accord (Z_{TUNE}) montée en série entre le générateur (G) et la charge (CH) et une impédance de charge (Z_{LOAD}) montée entre le générateur (G) et une masse, et
• au moins une paire d'étages additionnels (S2, S'2) apte à réaliser l'adaptation d'impédance, simultanée, entre le générateur et la charge pour la deuxième fréquence, ladite paire d'étages additionnels (S2, S'2) comprenant :
- un premier étage additionnel (S2) comportant un circuit de charge (C2) monté en parallèle par rapport à l'impédance de charge (Z_{LOAD}) de l'étage (S1) d'adaptation d'impédance, ledit circuit de charge (C2) comprenant au moins une inductance (L_{load2}) et un condensateur (C_{load2}) montés en série, et
- un deuxième étage additionnel (S'2) comportant un circuit d'accord (C'2) monté en série par rapport à l'impédance d'accord (Z_{TUNE}) de l'étage (S1) d'adaptation d'impédance, ledit circuit d'accord (C'2) comprenant au moins une inductance (L'ₜᵤₙₑ₂) et un condensateur (C'ₜᵤₙₑ₂) montés en parallèle,
l'étage d'adaptation d'impédance (S1) étant par ailleurs monté entre le premier étage additionnel (S2) et le deuxième étage additionnel (S'2),
ledit circuit étant **caractérisé en ce qu'**il comprend au moins une paire supplémentaire d'étages additionnels (S3, S'3) apte à réaliser l'adaptation d'impédance, simultanée, entre le générateur et la charge pour une troisième fréquence distincte desdites première et deuxième fréquences, ladite au moins une paire supplémentaire d'étages additionnels (S3, S'3) comportant :
- un premier étage additionnel (S3) supplémentaire comportant un circuit de charge (C3) monté en parallèle par rapport à l'impédance de charge (Z_{TUNE}) de l'étage (S1) d'adaptation d'impédance, ledit circuit de charge (C3) comprenant au moins une inductance (L_{load3}) et une condensateur (C_{load3}) montés en série,
- un deuxième étage additionnel (S'3) supplémentaire comportant un circuit d'accord (C'3) monté en série par rapport à l'impédance d'accord (Z_{TUNE}) de l'étage (S1) d'adaptation d'impédance, ledit circuit d'accord (C'3) comprenant au moins un inductance (L'ₜᵤₙₑ₃) et une condensateur (C'ₜᵤₙₑ₃) montés en parallèle,
l'ensemble formé par l'étage (S1) d'adaptation d'impédance ainsi que par la paire d'étages additionnels (S2, S'2) étant par ailleurs monté entre le premier étage additionnel (S3) supplémentaire et le deuxième étage additionnel (S'3) supplémentaire.

2. Circuit (100, 100') selon l'une des revendications précédentes, **caractérisé en ce que** la valeur d'au moins l'un de l'inductance ou du condensateur de l'un au moins des étages additionnels (S2, S'2 ; S3, S'3) est réglable.

3. Circuit (100, 100') selon l'une des revendications précédentes, **caractérisé en ce que** le circuit (C1) de l'étage (S1) d'adaptation d'impédance est constitué d'une impédance d'accord (Z_{TUNE}) être montée en série entre le générateur (G) et la charge (CH) et d'une impédance de charge (Z_{LOAD}) montée entre le générateur (G) et ladite masse.

4. Circuit (100, 100') selon la revendication précédente, **caractérisé en ce que** l'impédance d'accord (Z_{TUNE}) comprend une inductance (Lₜᵤₙₑ) montée en série avec un condensateur (Cₜᵤₙₑ) et l'impédance de charge (Z_{load}) comprend un condensateur (C_{load}).

5. Circuit (100, 100') selon la revendication précédente, **caractérisé en ce que** l'impédance d'accord (Z_{TUNE}) est constituée d'une inductance (Lₜᵤₙₑ) montée en série avec un condensateur (Cₜᵤₙₑ) et l'impédance de charge (Z_{load}) est constitué d'un condensateur (C_{load}).

6. Circuit (100, 100') selon l'une des revendications 1 à 3, **caractérisé en ce que** le circuit (C1) comprend en outre une autre impédance de charge (Z'_{LOAD}) montée entre la charge (CH) et ladite masse de sorte que l'impédance d'accord (Z_{TUNE}) est montée entre les deux impédances de charge (Z_{LOAD}, Z'_{LOAD}).

7. Circuit (100, 100') selon l'une des revendications 1 à 3, **caractérisé en ce que** le circuit (C1) comprend en outre une autre impédance d'accord (Z'_{TUNE}) montée en série entre le générateur (G) et la charge (CH) de sorte que l'impédance de charge (Z_{LOAD}) est montée entre les deux impédances d'accord (Z_{TUNE}, Z'_{TUNE}).

8. Ensemble (200, 200') comprenant :
- une charge (CH), et
- un générateur (G) apte à transmettre à la charge un signal d'alimentation comportant au moins une première fréquence et une deuxième fréquence distinctes l'une de l'autre,
**caractérisé en ce que** ledit ensemble (200, 200') comprend en outre un circuit (100, 100') d'adaptation d'impédance selon l'une des revendications précédentes monté entre le générateur (G) et la charge (CH) de sorte que d'une part, le premier étage additionnel (S2, S3) qui comporte le circuit de charge (C2, C3) le plus externe dudit circuit (100, 100') d'adaptation d'impédance soit connecté au générateur (G) et de sorte que d'autre part, le deuxième étage additionnel (S'2, S'3) qui comporte le circuit d'accord (C'2, C'3) le plus externe dudit circuit (100, 100') d'adaptation d'impédance soit connecté à la charge (CH).

9. Ensemble (200, 200') selon la revendication précédente, **caractérisé en ce que** la première fréquence est une fréquence fondamentale dudit signal d'alimentation et la deuxième fréquence, et le cas échéant toute fréquence supplémentaire, est l'une de ses harmoniques.

10. Ensemble (200, 200') selon l'une des revendications 8 ou 9, **caractérisé en ce qu'**il comprend un capteur (CF) de fréquence situé entre le générateur (G) et ledit circuit (100, 100') d'adaptation d'impédance.

11. Ensemble (200, 200') selon l'une des revendications 8 à 10, **caractérisé en ce que** la charge (CH) est un réacteur plasma couplé capacitivement.

12. Utilisation d'un ensemble (200, 200') selon la revendication 11 dans laquelle le générateur (G) transmet un signal d'alimentation ne comportant qu'une seule fréquence en direction du réacteur plasma couplé capacitivement, et dans laquelle on analyse les données fréquentielles issues du capteur (CF) de fréquences, en retour du réacteur plasma couplé capacitivement, pour déterminer si un procédé de gravure en cours dans le réacteur plasma est terminé ou non.

## Patentansprüche

1. Impedanzanpassungsschaltung (100, 100'), die dazu geeignet ist, eine gleichzeitige Impedanzanpassung zwischen dem Generator (G) und der Last (CH) für ein Versorgungssignal auszuführen, das mindestens eine erste Frequenz, eine zweite Frequenz und eine dritte Frequenz, die voneinander unterschiedlich sind, umfasst, wobei die Schaltung (100) umfasst:
• eine Impedanzanpassungsstufe (S1), die dazu geeignet ist, die Impedanzanpassung zwischen dem Generator und der Last für die erste Frequenz auszuführen, wobei diese Stufe (S1) eine Schaltung (C1) umfasst, die mindestens eine Abstimmungsimpedanz (Z_{TUNE}) umfasst, die zwischen dem Generator (G) und der Last (CH) in Reihe geschaltet ist, und eine Lastimpedanz (Z_{LOAD}), die zwischen dem Generator (G) und einer Masse montiert ist, und
• mindestens ein Paar von Zusatzstufen (S2, S'2), das dazu geeignet ist, die Impedanzanpassung gleichzeitig zwischen dem Generator und der Last für die zweite Frequenz auszuführen, wobei das Paar von Zusatzstufen (S2, S'2) umfasst:
- eine erste Zusatzstufe (S2), die eine Lastschaltung (C2) umfasst, die in Bezug auf die Lastimpedanz (Z_{LOAD}) der Impedanzanpassungsstufe (S1) parallel geschaltet ist, wobei die Lastschaltung (C2) mindestens eine Induktivität (L_{load2}) und einen Kondensator (C_{load2}), die in Reihe geschaltet sind, umfasst, und
- eine zweite Zusatzstufe (S'2), die eine Abstimmungsschaltung (C'2), die in Bezug auf die Abstimmungsimpedanz (Z_{TUNE}) der Impedanzanpassungsstufe (S1) in Reihe geschaltet ist, wobei die Abstimmungsschaltung (C'2) mindestens eine Induktivität (L'ₜᵤₙₑ₂) und einen Kondensator (C'ₜᵤₙₑ₂), die parallel geschaltet sind, umfasst,
wobei die Impedanzanpassungsstufe (S1) außerdem zwischen der ersten Zusatzstufe (S2) und der zweiten Zusatzstufe (S'2) montiert ist,
wobei die Schaltung **dadurch gekennzeichnet ist, dass** sie mindestens ein Paar zusätzlicher Zusatzstufen (S3, S'3) umfasst, das dazu geeignet ist, die gleichzeitige Impedanzanpassung zwischen dem Generator und der Last für eine dritte Frequenz auszuführen, die von der ersten und der zweiten Frequenz unterschiedlich ist, wobei das mindestens eine zusätzliche Paar von Zusatzstufen (S3, S'3) umfasst:
- eine erste zusätzliche Zusatzstufe (S3), die eine Lastschaltung (C3) umfasst, die in Bezug auf die Lastimpedanz (Z_{TUNE}) der Impedanzanpassungsstufe (S1) parallel geschaltet ist, wobei die Lastschaltung (C3) mindestens eine Induktivität (L_{load3}) und einen Kondensator (C_{load3}), die in Reihe geschaltet sind, umfasst,
- eine zweite zusätzliche Zusatzstufe (S'3), die eine Abstimmungsschaltung (C'3) umfasst, die in Bezug auf die Abstimmungsimpedanz (Z_{TUNE}) der Impedanzanpassungsstufe (S1) in Reihe geschaltet ist,
wobei die Abstimmungsschaltung (C'3) mindestens eine Induktivität (L'ₜᵤₙₑ₃) und einen Kondensator (C'ₜᵤₙₑ₃), die parallel geschaltet sind, umfasst,
wobei die Einheit, die von der Impedanzanpassungsstufe (S1) sowie von dem Paar von Zusatzstufen (S2, S'2) gebildet wird, außerdem zwischen der ersten zusätzlichen Zusatzstufe (S3) und der zweiten zusätzlichen Zusatzstufe (S'3) montiert ist.

2. Schaltung (100, 100') nach einem der vorstehenden Ansprüche, **dadurch gekennzeichnet, dass** der Wert mindestens einer der Induktivität oder des Kondensators mindestens einer der Zusatzstufen (S2, S'2; S3, S'3) einstellbar ist.

3. Schaltung (100, 100') nach einem der vorstehenden Ansprüche, **dadurch gekennzeichnet, dass** die Schaltung (C1) der Impedanzanpassungsstufe (S1) aus einer Abstimmungsimpedanz (Z_{TUNE}) besteht, die zwischen dem Generator (G) und der Last (CH) in Reihe geschaltet sein, und einer Lastimpedanz (Z_{LOAD}), die zwischen dem Generator (G) und der Masse montiert ist.

4. Schaltung (100, 100') nach dem vorstehenden Anspruch, **dadurch gekennzeichnet, dass** die Abstimmungsimpedanz (Z_{TUNE}) eine Induktivität (Lₜᵤₙₑ) umfasst, die mit einem Kondensator (Cₜᵤₙₑ) in Reihe geschaltet ist, und die Lastimpedanz (Z_{load}) einen Kondensator (C_{load}) umfasst.

5. Schaltung (100, 100') nach dem vorstehenden Anspruch, **dadurch gekennzeichnet, dass** die Abstimmungsimpedanz (Z_{TUNE}) aus einer Induktivität (Lₜᵤₙₑ) besteht, die mit einem Kondensator (Cₜᵤₙₑ) in Reihe geschaltet ist, und die Lastimpedanz (C_{load}) aus einem Kondensator (C_{load}) besteht.

6. Schaltung (100, 100') nach einem der Ansprüche 1 bis 3, **dadurch gekennzeichnet, dass** die Schaltung (C1) außerdem eine andere Lastimpedanz (Z'_{LOAD}) umfasst, die zwischen der Last (CH) und der Masse derart montiert ist, dass die Abstimmungsimpedanz (Z_{TUNE}) zwischen den beiden Lastimpedanzen (Z_{LOAD}, Z'_{LOAD}) montiert ist.

7. Schaltung (100, 100') nach einem der Ansprüche 1 bis 3, **dadurch gekennzeichnet, dass** die Schaltung (C1) außerdem eine andere Abstimmungsimpedanz (Z'_{TUNE}) umfasst, die zwischen dem Generator (G) und der Last (CH) derart in Reihe geschaltet ist, dass die Lastimpedanz (Z_{LOAD}) zwischen den beiden Abstimmungsimpedanzen (Z_{TUNE}, Z'_{TUNE}) montiert ist.

8. Einheit (200, 200'), die umfasst:
- eine Last (CH), und
- einen Generator (G), der dazu geeignet ist, ein Versorgungssignal zu der Last zu übertragen, das mindestens eine erste Frequenz und eine zweite Frequenz, die voneinander unterschiedlich sind, umfasst,
**dadurch gekennzeichnet, dass** die Einheit (200, 200') außerdem eine Impedanzanpassungsschaltung (100, 100') nach einem der vorstehenden Ansprüche umfasst, die zwischen dem Generator (G) und der Last (CH) derart montiert ist, dass einerseits die erste Zusatzstufe (S2, S3), die die äußerste Lastschaltung (C2, C3) auf der Impedanzanpassungsschaltung (100, 100') umfasst, mit dem Generator (G) verbunden ist, und andererseits derart, dass die zweite Zusatzstufe (S'2, S'3), die die äußerste Abstimmungsschaltung (C'2, C'3) auf der Impedanzanpassungsschaltung (100, 100') umfasst, mit der Last (CH) verbunden ist.

9. Einheit (200, 200') nach dem vorstehenden Anspruch, **dadurch gekennzeichnet, dass** die erste Frequenz eine Grundfrequenz des Versorgungssignals ist, und die zweite Frequenz und gegebenenfalls jede zusätzliche Frequenz eine ihrer Oberschwingungen ist.

10. Einheit (200, 200') nach einem der Ansprüche 8 oder 9, **dadurch gekennzeichnet, dass** sie einen Frequenzfühler (CF), der zwischen dem Generator (G) und der Impedanzanpassungsschaltung (100, 100') liegt, umfasst.

11. Einheit (200, 200') nach einem der Ansprüche 8 bis 10, **dadurch gekennzeichnet, dass** die Last (CH) ein kapazitiv gekoppelter Plasmareaktor ist.

12. Verwendung einer Einheit (200, 200') nach Anspruch 11, wobei der Generator (G) ein Versorgungssignal, das nur eine einzige Frequenz umfasst, in Richtung des Plasmareaktors, der kapazitiv gekoppelt ist, überträgt, und wobei die Frequenzdaten, die aus dem Frequenzfühler (CF) hervorgehen, bei Rückkehr von dem kapazitiv gekoppelten Plasmareaktor analysiert werden, um zu bestimmen, ob eine Gravurvorgehensweise, die in dem Plasmareaktor läuft, abgeschlossen ist oder nicht.

## Claims

1. Impedance matching circuit (100, 100') able to perform a simultaneous impedance matching between the generator (G) and the load (CH) for a power supply signal having at least one first frequency, one second frequency, and one third frequency, distinct from one another, said circuit (100) comprising:
- an impedance matching stage (S1) able to perform the impedance matching between the generator and the load for the first frequency, this stage (S1) having a circuit (C1) comprising at least one tuning impedance (Z_{TUNE}) mounted in series between the generator (G) and the load (CH) and a load impedance (Z_{LOAD}) mounted between the generator (G) and a ground, and
- at least one pair of additional stages (S2, S'2) able to perform the simultaneous impedance matching between the generator and the load for the second frequency, said pair of additional stages (S2, S'2) comprising:
- a first additional stage (S2) having a load circuit (C2) mounted in parallel with the load impedance (Z_{LOAD}) of the impedance matching stage (S1), said load circuit (C2) comprising at least one inductance (L_{load2}) and a capacitor (C_{load2}) mounted in series, and
- a second additional stage (S'2) having a tuning circuit (C'2) mounted in series with the tuning impedance (Z_{TUNE}) of the impedance matching stage (S1), said tuning circuit (C'2) comprising at least one inductance (L'ₜᵤₙₑ₂) and a capacitor (C'ₜᵤₙₑ₂) mounted in parallel,
the impedance matching stage (S1) being moreover mounted between the first additional stage (S2) and the second additional stage (S'2),
said circuit being **characterised in that** it comprises at least one additional pair of additional stages (S3, S'3) able to perform the simultaneous impedance matching, between the generator and the load for a third frequency, distinct from said first and second frequencies, said at least one additional pair of additional stages (S3, S'3) having:
- a supplementary first additional stage (S3) having a load circuit (C3) mounted in parallel with the load impedance (Z_{TUNE}) of the impedance matching stage (S1), said load circuit (C3) comprising at least one inductance (L_{load3}) and a capacitor (C_{load3}) mounted in series,
- a supplementary second additional stage (S'3) having a tuning circuit (C'3) mounted in series with the tuning impedance (Z_{TUNE}) of the impedance matching stage (S1),
said tuning circuit (C'3) comprising at least one inductance (L'ₜᵤₙₑ₃) and a capacitor (C'ₜᵤₙₑ₃) mounted in parallel,
the assembly formed by the impedance matching stage (S1) as well as by the pair of additional stages (S2, S'2) being moreover mounted between the supplementary first additional stage (S3) and the supplementary second additional stage (S'3).

2. Circuit (100, 100') according to one of the preceding claims, **characterised in that** the value of at least one of the inductance or of the capacitor of at least one of the additional stages (S2, S'2; S3, S'3) is adjustable.

3. Circuit (100, 100') according to one of the preceding claims, **characterised in that** the circuit (C1) of the impedance matching stage (S1) is constituted of a tuning impedance (Z_{TUNE}) be mounted in series between the generator (G) and the load (CH) and of a load impedance (Z_{LOAD}) mounted between the generator (G) and said ground.

4. Circuit (100, 100') according to the preceding claim, **characterised in that** the tuning impedance (Z_{TUNE}) comprises an inductance (Lₜᵤₙₑ) mounted in series with a capacitor (Cₜᵤₙₑ) and the load impedance (Z_{load}) comprises a capacitor (C_{load})·

5. Circuit (100, 100') according to the preceding claim, **characterised in that** the tuning impedance (Z_{TUNE}) is constituted of an inductance (Lₜᵤₙₑ) mounted in series with a capacitor (Cₜᵤₙₑ) and the load impedance (Z_{load}) is constituted of a capacitor (C_{load})·

6. Circuit (100, 100') according to one of claims 1 to 3, **characterised in that** the circuit (C1) further comprises another load impedance (Z'_{LOAD}) mounted between the load (CH) and said ground such that the matching impedance (Z_{TUNE}) is mounted between the two load impedances (Z_{LOAD}, Z'_{LOAD}).

7. Circuit (100, 100') according to one of claims 1 to 3, **characterised in that** the circuit (C1) further comprises another matching impedance (Z'_{TUNE}) mounted in series between the generator (G) and the load (CH) such that the load impedance (Z_{LOAD}) is mounted between the two matching impedances (Z_{TUNE}, Z'_{TUNE}).

8. Assembly (200, 200') comprising:
- a load (CH), and
- a generator (G) able to transmit to the load, a power supply signal having at least one first frequency and one second frequency, distinct from one another,
**characterised in that** said assembly (200, 200') further comprises an impedance matching circuit (100, 100') according to one of the preceding claims, mounted between the generator (G) and the load (CH) such that on the one hand, the first additional stage (S2, S3) which has the most outer load circuit (C2, C3) from said impedance matching circuit (100, 100') is connected to the generator (G) and such that, on the other hand, the second additional stage (S'2, S'3) which has the most outer matching circuit (C'2, C'3) from said impedance matching circuit (100, 100') is connected to the load (CH).

9. Assembly (200, 200') according to the preceding claim, **characterised in that** the first frequency is a fundamental frequency of said power supply signal and the second frequency, and if necessary, any additional frequency, is one of its harmonics.

10. Assembly (200, 200') according to one of claims 8 or 9, **characterised in that** it comprises a frequency sensor (CF) located between the generator (G) and said impedance matching circuit (100, 100').

11. Assembly (200, 200') according to one of claims 8 to 10, **characterised in that** the load (CH) is a capacitively coupled plasma reactor.

12. Use of an assembly (200, 200') according to claim 11, wherein the generator (G) transmits a power supply signal only having one single frequency in the direction of the capacitively coupled plasma reactor, and wherein the frequency data coming from the frequency sensor (CF) are analysed, in return from the capacitively coupled plasma reactor, to determine if an ongoing etching process in the plasma reactor is ended or not.
